Europäisches Patentamt

(19) European Patent Office

Office européen des brevets

(11) Publication number: **0 181 011**
**A2**

# (12) EUROPEAN PATENT APPLICATION

(21) Application number: **85200848.1**

(22) Date of filing: **25.05.85**

(51) Int. Cl.⁴: **G 01 R 31/28**
**H 03 K 19/003**

(30) Priority: **08.11.84 US 670370**

(43) Date of publication of application:
**14.05.86 Bulletin 86/20**

(84) Designated Contracting States:
**DE FR GB NL**

(71) Applicant: **Monolithic Memories, Inc.**
**2175 Mission College Blvd.**
**Santa Clara, CA 95050(US)**

(72) Inventor: **Bosnyak, Robert J.**
**240 McKee Road**
**Felton California 95018(US)**

(74) Representative: **Noz, Franciscus Xaverius, Ir. et al,**
**Algemeen Octrooibureau P.O. Box 645**
**NL-5600 AP Eindhoven(NL)**

(54) **A method and circuit detecting the logic state of internal nodes in sequential logic circuits.**

(57) A circuit is provided which overrides the normal output signal of a sequential logic circuit, and provides an output signal indicative of the logical state of an internal node which is normally accessible via the output terminals of the sequential logic circuit. These output signals are provided to faciliate adequate testing of the sequential logic circuit in a minimum of time.

FIG. I

./...

FIG. 4

FIG. 6

-1-

A METHOD AND CIRCUIT FOR DETECTING
THE LOGIC STATE OF INTERNAL NODES
IN SEQUENTIAL LOGIC CIRCUITS

## BACKGROUND OF THE INVENTION

This invention relates to sequential logic circuit testing, and particularly to means for determining the internal logic states of sequential logic circuits.

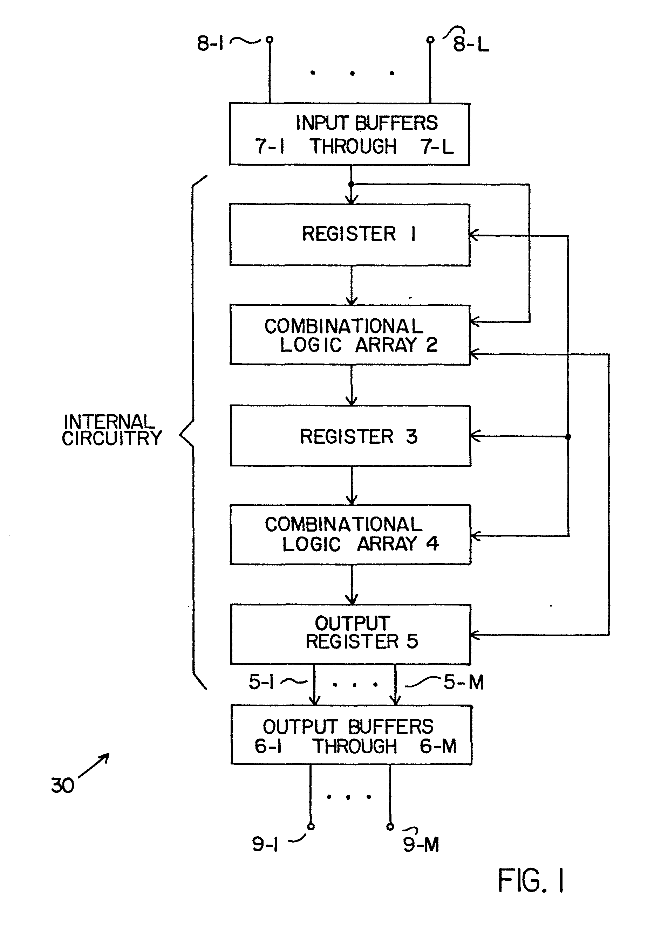

Figure 1 is a block diagram of a typical sequential logic circuit. Input signals are provided on input terminals 8-1 through 8-L. These input signals are buffered via input buffers 7-1 through 7-L, respectively. These buffered signals are stored in register 1 and are provided to combinational logic array 2 which combines these signals from register 1 with other signals provided internally in combinational logic array 2. The output signal of combinational logic array 2 is stored in register 3. Combinational logic array 4 combines the output signals provided by register 3 and provides output signals to register 1, register 3, and output register 5. Output register 5 provides output signals on output leads 5-1 through 5-M to output buffers 6-1 through 6-M, which in turn provide output signals on output terminals 9-1 through 9-M, respectively. Examples of typical prior art sequential logic circuits are the SN 54/74S508, SN

54/74S516, and various registered programmable logic array devices manufactured and sold by Monolithic Memories, Inc., the assignee of this invention.

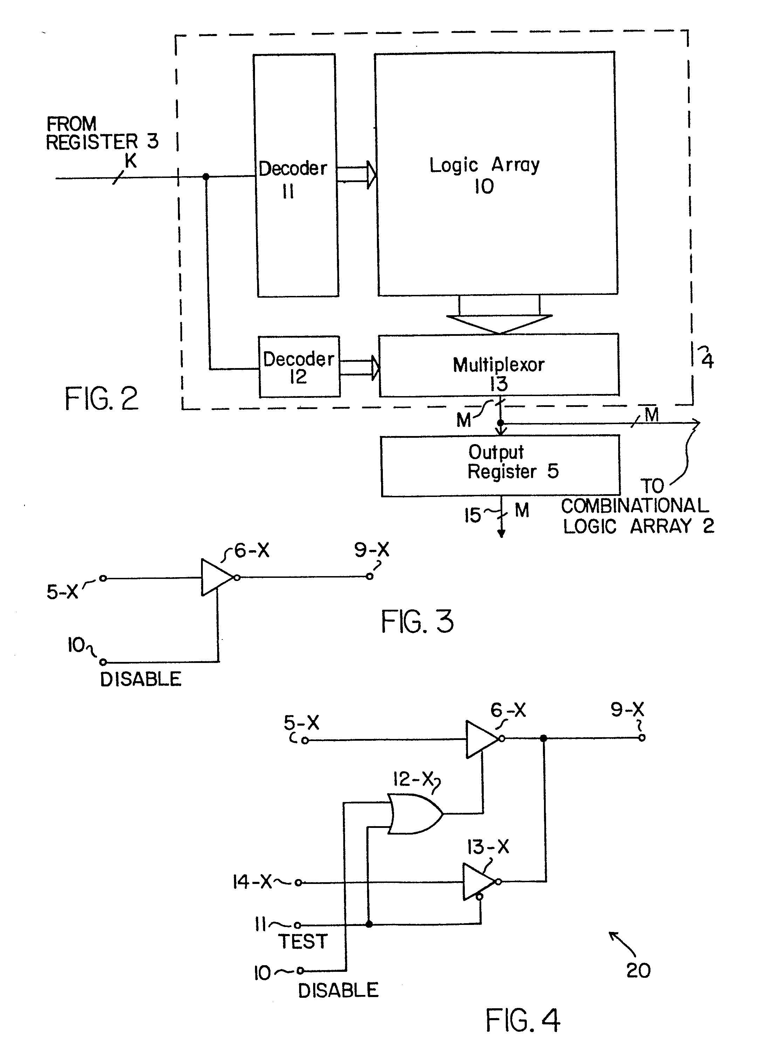

Figure 2 is a block diagram of combinational logic array 4 and output register 5 of Figure 1. Decoders 11 and 12 decode the K input signals (where K is a selected positive integer) provided by register 3 (Figure 1) and provide the decoded signals to logic array 10 and multiplexer 13. Multiplexer 13 provides M (where M is a selected positive integer) selected output signals from logic array 10 on output bus 15 in response to the signals provided by decoder 12. It is to be understood that output register 5 is formed of M single bit registers (not shown).

As with any manufacturing process, a certain number of sequential logic circuits produced will have minor defects in their circuitry. In addition, even after an integrated circuit containing sequential logic circuitry is tested and installed in a device by an end user, a number of phenomena can cause the sequential logic circuit to malfunction. In certain applications, such as military or medical applications, it is imperative that the users of machines containing these sequential logic circuits are certain that the sequential circuits are operating properly. In order to provide this assurance, testing methods have been developed in the art to compare known input signals provided to the sequential logic circuit to the output signals expected in response to the known input signals. However, in order to completely test complex sequential logic circuits, this method of providing known input signals to the input terminals and processing these known input signals through a sequential logic circuit to provide an expected output signal, requires a large amount of time because the input signal must be cycled through every portion of the sequential logic circuit to ensure that the entire logic circuit is operating properly.

A circuit which may facilitate testing by providing an output signal indicative of the internal state of a logic array is described by Balasubramanian et al., U.S. Patent No. 4,140,967, entitled "Merged Array PLA Device, Circuit, Fabrication Method and Testing Technique", issued February 20, 1979. However, during this testing of internal nodes, the circuit of Balasubramanian et al. alters the output signal stored in its output registers by storing the signal from the internal node being tested, rather than the normal output signal. Thus, the actual operation of the Balasubramanian device is interrupted during the testing of internal nodes. Means for rapidly testing a sequential logic circuit are desirable which will not alter the stored states of the sequential logic unit.

## SUMMARY

In one embodiment of a circuit constructed in accordance with the teachings of this invention, a circuit is provided which overrides the normal output signal of a sequential logic circuit and provides a test output signal indicative of the logical state of an internal register or node of the combinational logic circuit which is not normally accessible via an output terminal of the sequential logic circuit, while simultaneously maintaining the normal output signal in order not to interrupt the operation of the circuit. The test output signal is provided to faciliate adequate testing of the sequential logic circuit in a minimum of time.

In another embodiment of a circuit constructed in accordance with the teachings of this invention, a circuit is provided which provides on an output lead a selected one of several signals from internal nodes or registers which are not normally accessible via an output terminal of the sequential logic circuit.

## BRIEF DESCRIPTION OF THE DRAWING

Figure 1 is a block diagram of a prior art sequential logic circuit;

Figure 2 is a block diagram of combinational logic array 4 and output register 5 of Figure 1;

Figure 3 is a logic diagram of a typical output buffer 6-X of Figure 1;

Figure 4 is a logic diagram of one embodiment of an output buffer used in a sequential logic circuit constructed in accordance with the teachings of the present invention;

Figure 5 is a schematic diagram of another embodiment of an output buffer used in a sequential logic circuit constructed in accordance with the teachings of the present invention; and

Figure 6 is a schematic diagram of another embodiment of an output buffer used in a sequential logic circuit constructed in accordance with the teachings of this invention.

## DETAILED DESCRIPTION

Figure 3 is a logic diagram of a typical prior art output buffer 6-X, where X is a positive integer greater than or equal to 1 and less than or equal to M of Figure 1 (i.e. any one of output buffers 6-1 through 6-M of Figure 1). Output buffer 6-X is a three state output buffer. When a logical 0 (approximately 0 volts) disable signal is provided on disable terminal 10, output buffer 6-X is enabled and serves as an inverter to provide on output lead 9-X an output signal of either a logical 1 (approximately 5 volts) or a logical 0, which is the inverse of the input signal provided on input lead 5-X from output register 5-X. When a logical 1 disable signal is provided on disable terminal 10, output buffer 6-X is disabled and can neither source nor sink current on output terminal 9-X and thus provides a high impedance output signal on output lead 9-X.

Figure 4 is a logic diagram of one embodiment of the present invention for use as an output buffer of a sequential logic circuit. The disable signal applied to disable terminal 10 selectively enables or disables output buffer 6-X in the manner described for the circuit of Figure 3. Output circuit 20 includes test input lead 11. When the test input signal provided on test input lead 11 is a logical 1, OR gate 12-X provides a logical 1 output signal to the disable input lead of output buffer 6-X, thus disabling output buffer 6-X such that output buffer 6-X neither sources nor sinks current on output lead 9-X.

The test input signal provided on test input terminal 11 is also provided to the enable input lead of buffer 13-X. When the enable signal provided on the enable input lead of buffer 13-X is a logical 1, buffer 13-X is enabled and provides an output signal on output lead 9-X which is the inverse of the input signal provided on input terminal 14-X. Input terminal 14-X is connected, for example, to a selected internal node (not shown) of the sequential logic circuit incorporating circuit 20. Conversely, when the test signal on test input terminal 11 of buffer 13-X is a logical 0, buffer 13-X is disabled and neither sources nor sinks current to output lead 9-X. In summary, when a logical 1 test signal is provided on test input terminal 11, the inverse of the signal provided on input terminal 14-X is provided on output terminal 9-X. Conversely, when a logical 0 test signal is provided on test input terminal 11 and a logical 0 disable signal is provided on disable input terminal 10, the inverse of the input signal provided on input lead 5-X from output register 5 is provided on output terminal 9-X.

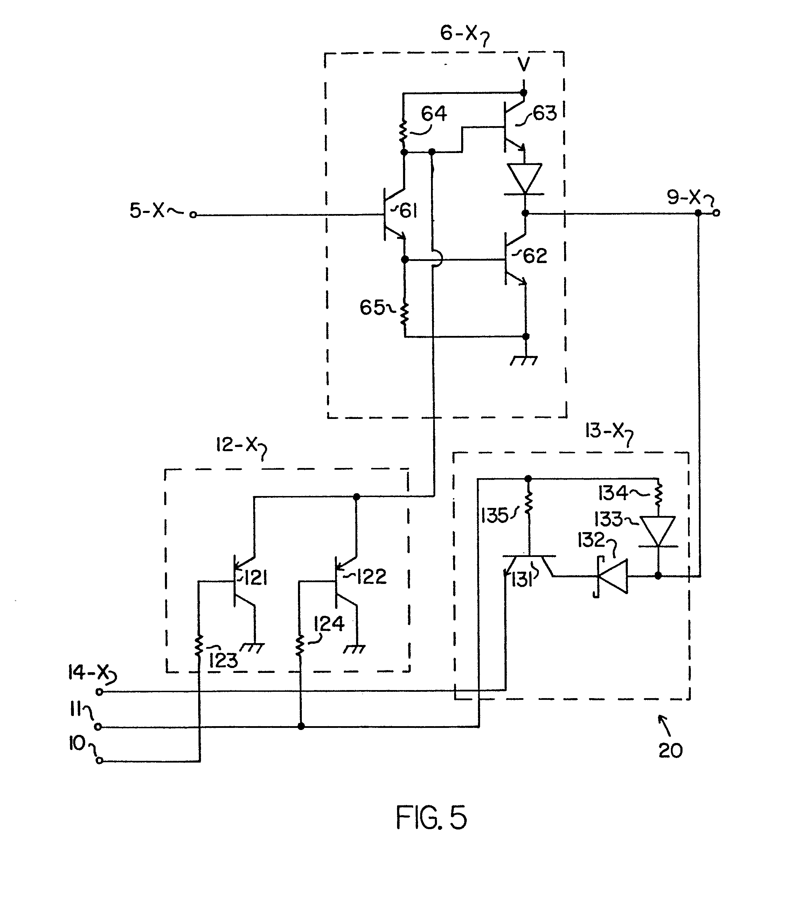

Figure 5 is a schematic diagram of another embodiment of circuit 20 which is constructed in accordance with the teachings of this invention. A logical 0 provided on either enable input terminal 10 or test input terminal 11 causes PNP transistor 121 or PNP transistor 122, respectively, to turn on. When transistor 121 and/or transistor 122 is on, the base of NPN transistor 63 is pulled low and transistor 63 is therefore turned off. Furthermore, if NPN transistor 61 is turned on by a logical 1 input signal on input terminal 5-X, the base of NPN transistor 62 is not pulled up, since the collector of transistor 61 is pulled low. Thus, with transistors 121 and/or 122 turned on, neither transistor 62 or 63 can turn on, regardless of the input signal applied to input lead 5-X. Thus, output buffer 6-X is disabled and can neither source nor sink current on output terminal 9-X. Alternatively, when transistors 121 and 122 are off and a logical 1 is provided on input terminal 5-X, NPN transistor 61 is turned on and thus provides current to the base of transistor 62, therefore turning on transistor 62 and connecting output terminal 9-X to ground, providing a logical 0 (i.e., the inverse of the input signal received on input lead 5-X) on output terminal 9-X. Conversely, when transistors 121 and 122 are off and a logical 0 is provided on lead 5-X, transistor 61 is off and resistor 64 provides current from positive voltage source V to the base of transistor 63, thereby turning on transistor 63 and thus connecting output terminal 9-X to positive voltage source V in order to provide a logical 1 on output terminal 9-X. Therefore, when transistors 121 and 122 are off, buffer 6-X provides on output terminal 9-X the inverse of the input signal provided on input terminal 5-X.

Buffer 13-X provides an output signal on terminal 9-X in response to the signal on terminal 14-X when a logical 1 test signal is provided on test input terminal 11. When a logical 1 test signal is provided on test input terminal 11 and a logical 1 input signal is provided on input terminal 14-X, NPN transistor 131 is not forward biased and therefore does not conduct. Also, diode 133 is forward biased and therefore provides a logical 1 on output terminal 9-X. Conversely, when a logical 1 test signal is provided on test input terminal 11 and a logical 0 input signal is provided on input terminal 14-X, transistor 131 is forward biased and is therefore on, and diode 132 is forward biased, thereby providing a logical 0 on output terminal 9-X. When a logical 0 is provided on test input terminal 11, transistor 131 and diode 133 are not forward biased, therefore buffer 13-X is disabled and can neither source nor sink current to output terminal 9-X.

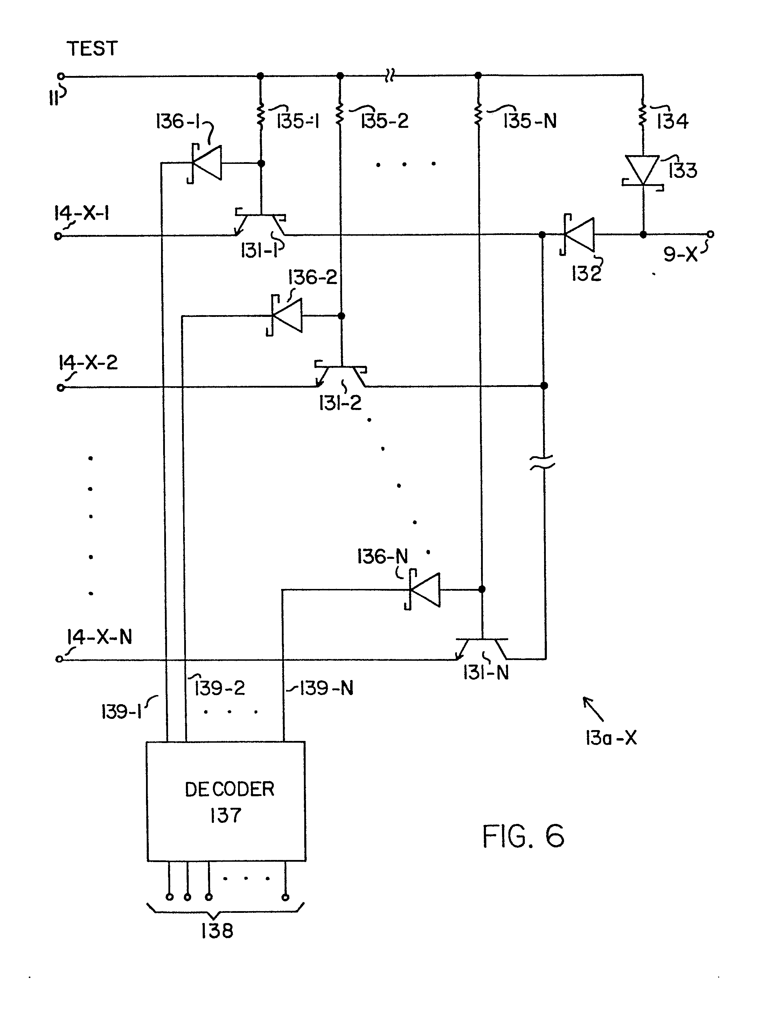

Figure 6 is a schematic diagram of another embodiment of a circuit constructed in accordance with the teachings of the present invention. Buffer 13a-X serves in a similar capacity as buffer 13-X in Figure 5. Buffer 13a-X includes means for providing on output terminal 9-X a selected one of several input signals as provided on input terminals 14-X-1 through 14-X-N, where N is a positive integer. The particular signal to be provided on output terminal 9-X is selected by an address input signal provided on input port 138. Decoder 137 provides a logical 1 on a selected one of output leads 139-1 through 139-N in response to the address input signal on port 138 and provides a logical 0 on the remaining deselected leads. For example, if it is desired to provide on output terminal 9-X the signal provided on input terminal 14-X-1, an input address signal is provided on port 138 to decoder 137 which causes a logical 1 to be provided on lead 139-1, thus reverse biasing diode 136-1. Because a logical 0 is provided on the deselected leads 139-2 through 139-N, diodes 136-2 through 136-N are forward biased and NPN transistors 131-2 through 131-N are turned off. When it is desired to provide on output lead 9-X a signal provided on a selected one of terminals 14-X-1 through 14-X-N, a logical 1 test signal is provided on test input lead 11. Thus, for this example, if the input signal provided on input terminal 14-X-1 is a logical 0, NPN transistor 131-1 is forward biased. Therefore, transistor 131-1 is turned on and a logical 0 is provided through diode 132 to terminal 9-X. If the signal provided on input terminal 14-X-1 is a logical 1, transistor 131-1 is turned off and output terminal 9-X is pulled to a logical 1 through resistor 134 and diode 133.

By providing means for generating an output signal indicative of internal logic states of a sequential logic circuit which means does not affect the data stored in any register in the circuit, this invention provides means for testing the operation of the sequential logic circuit quickly without disturbing the data flow of the sequential logic circuit. Input monitoring circuitry (not shown) can be provided to determine when the input signal of the sequential logic circuitry corresponds with a reference input signal. Using the output circuitry of any of the embodiments of this invention, output monitoring circuitry (not shown) may then access internal nodes of the sequential logic circuit to determine if the reference input signal generated the appropriate responses in the internal circuitry of the sequential logic circuit. Because internal states of the sequential logic circuit can be monitored, the sequential logic circuit may be rapidly monitored to ensure its proper operation without disturbing its operation and without waiting for the circuit signals to propagate through the entire sequential logic circuit.

While this specification illustrates specific embodiments of this invention, it is not to be construed as limiting the scope of the invention. Other embodiments of the invention will become readily apparent to those skilled in the art in light of the teachings of the specification.

The figures used in the claims are only meant to explain more clearly the intention of the invention and are not supposed to be any restriction concerning the interpretation of the invention.

I CLAIM

1.    The method for testing sequential logic circuits including at least one register, comprising the steps of:
monitoring the input signals to said sequential logic circuit;
providing output signals indicative of internal states of said sequential logic circuit without disturbing the contents of said at least one register; and
comparing said output signals to the expected output signal of said sequential logic circuit which are expected in response to said input signals.

2.    An output buffer circuit for a sequential logic circuit having a first input terminal, a second input terminal, a test input terminal, and an output terminal, comprising:
first data transfer means having an input lead connected to said first input terminal, an output lead connected to said output terminal, and a control input lead connected to said test input lead, wherein when a first signal is provided on said control input lead, said first data transfer means provides on said output terminal a signal related to the input signal provided on said input lead, and wherein when a second signal is provided on said control input lead said first data transfer means provides a high impedance on said output terminal; and

second data transfer means having an input lead connected to said second input terminal, an output lead connected to said output terminal, and a control input terminal connected to said test input terminal, wherein when said first signal is provided on said control input lead, said second data transfer means provides a high impedance on said output terminal, and wherein when said second signal is provided on said control lead said second data transfer means provides on said output terminal a signal related to the input signal provided on said input lead.

3.    An output buffer circuit for a sequential logic circuit having a first input terminal, a plurality of K second input terminals, where K is a positive integer, a test input terminal, an input select port, and an output terminal, comprising:

first data transfer means having an input lead connected to said first input terminal, an output lead connected to said output terminal, and a control input lead connected to said test input lead, wherein when a first signal is provided on said control input lead said first data transfer means provides on said output lead a signal related to the input signal provided on said first input terminal, and wherein when a second signal is provided on said control input lead said first data transfer means provides a high impedance on said output terminal; and

second data transfer means having K input leads, each uniquely connected to one of said K input terminals, an output lead connected to said output terminal, and a control input lead connected to said test input terminal, wherein when said first signal is provided on said control input lead said second data transfer means provides a high impedance on said output terminal and wherein when said second signal is provided on said control input lead said second data transfer means provides on said output terminal a signal related to a selected one of said K input signals provided on said K input terminals selected in response to signals provided on said input select port.

0181011

FIG. I

FIG. 2

FIG. 3

FIG. 4

0181011

FIG. 5

0181011

FIG. 6